(19) Europäisches Patentamt
European Patent Office
Office européen des brevets

(11) Numéro de publication : **0 385 829 B1**

(12)
# FASCICULE DE BREVET EUROPEEN

(45) Date de publication du fascicule du brevet :
**08.09.93 Bulletin 93/36**

(51) Int. Cl.⁵ : **H05K 3/12**

(21) Numéro de dépôt : **90400445.4**

(22) Date de dépôt : **19.02.90**

(54) **Procédé d'élaboration de moyens de connexion électrique, en particulier de substrats d'interconnexion de circuits hybrides.**

(30) Priorité : **20.02.89 FR 8902172**

(43) Date de publication de la demande :
**05.09.90 Bulletin 90/36**

(45) Mention de la délivrance du brevet :
**08.09.93 Bulletin 93/36**

(84) Etats contractants désignés :
**AT BE CH DE ES FR GB GR IT LI LU NL SE**

(56) Documents cités :
**EP-A- 0 163 478**

(73) Titulaire : **L'AIR LIQUIDE, SOCIETE ANONYME POUR L'ETUDE ET L'EXPLOITATION DES PROCEDES GEORGES CLAUDE
75, Quai d'Orsay
F-75321 Paris Cédex 07 (FR)**

(72) Inventeur : **Rotman, Frédéric, Teisan K.K.
9-1 Chinonome 1-chome, Koto-ku
Tokyo 135 (JP)**
Inventeur : **Navarro, Dominique
34 Palais des Amandiers, Villenave d'Ornon
F-33140 Pont De La Maye (FR)**
Inventeur : **Mellul, Sylvie
45, rue E. Derrien
F-94.400 Vitry-sur-Seine (FR)**

(74) Mandataire : **Le Moenner, Gabriel et al
L'AIR LIQUIDE, Société Anonyme pour l'étude et l'exploitation des procédés Georges Claude
75, Quai d'Orsay
F-75321 Paris Cédex 07 (FR)**

## Description

La présente invention se rapporte à l'élaboration de moyens de connexion électrique, en particulier de substrats d'interconnexion de circuits hybrides, du genre où l'on effectue sur un support le dépôt d'une couche épaisse d'encre ou pâte à base de métal en mettant en oeuvre successivement un séchage préliminaire d'élimination des solvants à une température de l'ordre de 100°C à 150°C, une cuisson comprenant :

a) une montée en température incorporant une phase d'élimination de résines polymères,
b) un palier de frittage à une température de l'ordre de 600°C à 1000°C, et
c) un refroidissement temporisé.

Dans cette technique d'interconnexion électronique, les substrats servent de support et d'élément d'interconnexion aux différents composants électroniques constituant le circuit, et à cet effet ils sont essentiellement formés d'un support mécanique jouant également le rôle de dissipateur thermique, sur lequel sont rapportées des couches épaisses conductrices, isolantes et/ou résistives, qui réalisent à partir de motifs variés, l'ensemble des interconnexions.

Les couches épaisses sont elles-mêmes réalisées à partir d'encres ou pâtes, qui sont essentiellement constituées d'une phase fonctionnelle, d'un liant inorganique et d'un véhicule organique (solvants et résines polymères qui assurent à la pâte une bonne rhéologie). La phase fonctionnelle assure les propriétés électriques de la couche au regard de la conductibilité, de la résistivité ou de l'isolation. Elle se présente sous forme de poudres qui sont métalliques pour les couches conductrices, à base de verre et de céramique pour les couches isolantes. Le liant inorganique a pour rôle d'assurer une bonne adhérence entre la couche et le support.

En pratique, le dépôt d'une couche d'encre crue sur le substrat s'effectue par sérigraphie selon un motif préalablement réalisé sur un écran : l'écran est un tamis, et le dépôt est obtenu par passage de l'encre au travers les mailles du tamis ; l'opération de séchage vise à éliminer les solvants, tandis que la cuisson de l'ensemble à haute température réalise par frittage et/ou fusion des constituants un film d'épaisseur comprise entre environ 5 microns et environ 50 microns, qui adhère à la surface du substrat.

La cuisson des couches d'encre après séchage représente une opération complexe de traitement thermique au cours de laquelle le rôle de l'atmosphère est primordial. En particulier, l'atmosphère a pour but de constituer un environnement adéquat à un déroulement aussi correct que possible des opérations de frittage et d'adhérence de la couche sur le substrat.

Dans le cas des encres conductrices à base de métaux nobles tels le platine, l'or, le palladium, l'argent, ainsi que pour les encres isolantes et résistives compatibles, la cuisson est réalisée sous atmosphère oxydante, généralement sous air. L'emploi d'une atmosphère oxydante telle que l'air est tout à fait approprié pour l'opération d'élimination des résines polymères restant dans la couche après séchage. L'oxygène présent dans l'atmosphère facilite cette élimination des résines par oxydation des composés organiques qui se vaporisent et se pyrolisent avec la montée en température.

Au contraire, dans le cas d'encres conductrices à base d'un métal non noble tel que le cuivre, ou autres matériaux dits compatibles, la cuisson nécessite une atmosphère inerte obtenue par l'emploi de gaz neutres tels l'azote, l'argon, l'hélium, le cas échéant une combinaison de ces gaz, afin d'éviter l'oxydation du métal. Dans une telle atmosphère inerte, l'élimination des résines polymères est souvent incomplète, ce qui entraîne un certain nombre de détériorations des couches, notamment une diminution de leur adhérence sur le substrat. Les mécanismes d'apparition de ces détériorations ont été étudiés et sont, en particulier, décrits par R.J. BACHER et V.P. SIUTA, dans un article intitulé "Firing Process-related Failure Mechanisms in Thick Film Copper Multilayers" paru dans "Proc. of the Electronic Components Conference, IEEE", 1986, pp. 471-480.

Cependant, compte tenu de ses propriétés particulièrement exceptionnelles (haute conductivité électrique, excellente soudabilité à l'étain-plomb, etc...), et de son faible coût, le cuivre reste un matériau recherché pour de nombreuses applications en microélectronique. C'est pourquoi, depuis plusieurs années, un grand nombre d'études ont été consacrées à l'amélioration de l'élimination des composés organiques, dans la technique mettant en oeuvre ces matériaux.

La recherche d'une solution, aussi simple et complète que possible, a conduit à s'intéresser au dopage de l'atmosphère inerte de cuisson avec un gaz ou un mélange de gaz qui soient réactifs vis-à-vis des composés organiques sans que le cuivre soit altéré. Il est connu, par exemple, que l'addition d'hydrogène et de vapeur d'eau dans une atmosphère neutre permet de contrôler le pouvoir oxydo-réducteur de cette atmosphère. Il est ainsi possible de déterminer de façon théorique des teneurs en hydrogène et en vapeur d'eau dont l'effet combiné est oxydant vis-à-vis des résines polymères et neutre par rapport au cuivre sur tout le cycle de cuisson considéré. D'autres dopants gazeux comme CO et $CO_2$ peuvent également être envisagés. Ainsi, W. Yext, E.A. Hayduk, Jr. et C.K. Fisher ont étudié une telle solution et décrivent l'influence des divers dopants dans un article intitulé "A Study of various Nitrogen-based Furnace Atmospheres and their Effects on Copper Thick-film Conductors and Dielectrics" paru dans "Hybrid Circuits, Number 12", janvier 1987, pp. 5-10, avec cette conclusion que certains gaz tels CO, $CO_2$, $H_2O$, $H_2$, lorsqu'ils sont ajoutés dans l'atmosphère de cuisson à base d'azote, détériorent au moins l'une des propriétés physiques (résistivité, adhérence, soudabilité) des couches épaisses de cuivre qui ont été traitées de cette façon.

Dans le cas d'additions combinées d'hydrogène et de vapeur d'eau, ces auteurs indiquent que l'adhérence ne se produit pas, et que la résistivité des couches est plus élevée que celle obtenue lors d'une cuisson sous une atmosphère d'azote sans addition. En outre, dans le cas de simples additions de vapeur d'eau jusqu'à des teneurs de 1,75 %, ils ont noté que l'adhérence de la couche épaisse de cuivre sur un substrat d'alumine 96 %, se détériore avec l'augmentation de la teneur en vapeur d'eau.

La présente invention a pour objectif de réaliser une atmosphère d'élaboration de couches épaisses qui, dans le cas d'encre ou pâte à base de métaux non nobles, tel le cuivre, ou autres matériaux compatibles, assure une bonne adhérence des couches, une qualité excellente et reproductible des propriétés électriques, mécaniques et thermiques de l'élément électronique, conditions nécessaires pour la réalisation et le bon fonctionnement de circuits électroniques.

Ces objectifs sont atteints de façon particulièrement inattendue selon l'invention en ce que l'atmosphère de la phase d'élimination des résines polymères présente une teneur en vapeur d'eau, comprise entre 50 ppm et 20000 ppm et en ce que l'atmosphère de frittage présente une teneur en vapeur d'eau inférieure à celle de l'atmosphère de la phase d'élimination des résines polymères, et en tout cas inférieure à 1000 ppm, les atmosphères de cuisson étant substantiellement exemptes d'hydrogène.

Selon une forme de mise en oeuvre de l'invention, la teneur en vapeur d'eau de l'atmosphère de la phase d'élimination des résines polymères est comprise entre 1000 et 10000 ppm. De même, il est préférable que la teneur en vapeur d'eau de l'atmosphère de frittage soit inférieure à 250 ppm.

Ces résultats, en contradiction apparente avec les travaux de Yext, Hayduck et Fisher mentionnés plus haut, résultent, semble-t-il, d'une approche plus fine et nuancée de la constitution des atmosphères de traitement. La première déduction que l'on peut faire est qu'il faut différencier une atmosphère d'élimination des résines polymères d'une atmosphère de frittage en ce sens que la première de ces atmosphères devient tout à fait satisfaisante avec une teneur déterminée en vapeur d'eau, de préférence comprise entre de l'ordre de 1000 ppm et 10000 ppm, alors que l'atmosphère de frittage, qui est à température nettement plus élevée, doit nécessairement voir sa teneur en vapeur d'eau réduite. Ceci peut être réalisé aisément, dans des fours continus, en différenciant nettement la zone d'élimination des résines polymères et de la zone de frittage.

Selon une forme de mise en oeuvre de l'invention, l'atmosphère de la phase d'élimination des résines polymères comprend de l'oxygène à une teneur pouvant aller jusqu'à quelques dizaines de ppm, alors que la teneur en oxygène de l'atmosphère de frittage et de refroidissement reste inférieure à 10 ppm.

Il est intéressant de constater qu'en présence de teneurs en vapeur d'eau, une teneur résiduelle d'oxygène dans la seule atmosphère d'élimination des résines polymères a un effet bénéfique, alors que cet oxygène doit être pratiquement proscrit de l'atmosphère de frittage à haute température.

Selon un mode opératoire préféré, l'atmosphère d'élimination des résines polymères est réalisée à partir d'un courant de gaz inerte, auquel on adjoint des proportions d'oxygène et d'hydrogène de formation catalytique de vapeur d'eau, avec élimination quasi-totale de l'hydrogène, le cas échéant avec un résiduel déterminé d'oxygène, façon à obtenir la teneur prédéterminée en vapeur d'eau et, le cas échéant, la teneur en oxygène. Cette mise en oeuvre, qui se substitue au barbotage habituel, est particulièrement intéressante, car elle permet une régulation stricte des valeurs de la teneur en vapeur d'eau et de la teneur résiduelle en oxygène, ce qui assure une reproductibilité industrielle et une possibilité d'automatisation de productions tout à fait fiables.

L'invention est maintenant décrite à l'aide d'un exemple de mise en oeuvre :

On a utilisé des encres commerciales à base de cuivre que l'on a cuites sous différentes atmosphères à base d'azote, après avoir été sérigraphiées et séchées en procédant de la façon qui est habituellement employée dans l'industrie.

Le motif de tests choisi comprend, entre autres, une lyre pour évaluer la résistivité et des plots de tailles différentes pour évaluer l'adhérence. Les plots sont des carrés de 1,5 mm ou 2 mm de côté. Ce motif a été sérigraphié sur des substrats carrés en alumine de 50,8 mm de côté. Le degré de pureté de l'alumine est de 96 %.

Les cuissons sous atmosphères ont été réalisées dans un four à passage industriel classique comprenant un tapis. Le cycle complet de cuisson qui a été choisi dure 55 minutes avec un palier de frittage à 900°C à plus ou moins 2°C pendant environ 10 minutes.

Après cuisson, un ensemble de tests électriques et mécaniques ont été réalisés, comprenant des mesures d'adhérence, de résistivité, de soudabilité, d'aptitude au microcablage.

Pour l'adhérence qui est un paramètre particulièrement critique dans le cas des couches épaisses cuivre, on a opéré de la façon suivante. Des crochets en cuivre ont été soudés à l'étain-plomb-argent (62-36-2) à 215°C sur des plots en cuivre. Puis ces crochets ont subi des tests de traction et les forces de rupture ont été mesurées afin d'évaluer le pouvoir d'adhérence.

Le vieillissement a consisté à placer sous étuve à 150°C, pendant 200h, des crochets soudés sur des plots avant de leur faire subir des tests de traction.

Le test n° 1 a consisté en une cuisson sous atmosphère d'azote sans addition de dopants gazeux, la teneur en vapeur d'eau est de 12 ppm, la teneur en oxygène de 4 ppm.

Le test n° 2 a consisté en une cuisson sous atmosphère d'azote avec addition de vapeur d'eau dans la zone d'élimination des résines polymères. Dans cette zone d'élimination des résines polymères, la teneur en vapeur d'eau est de 8000 ppm (0,8 %), la teneur en oxygène de 5 ppm. Dans la zone du palier de frittage, la teneur en eau est de 18 ppm et la teneur en oxygène de 3 ppm.

Résultats comparatifs :

|  | test n° 1 | test n° 2 |
|---|---|---|
| – Résistivité de la couche (milliohms/carré/18 microns) | $1,40 \pm 0,05$ | $1,42 \pm 0,05$ |
| – Adhérence initiale (N/mm²) | $25,1 \pm 3,5$ | $39,6 \pm 3,1$ |
| – Adhérence après vieillissement (N/mm²) | $21,8 \pm 2,0$ | $30,4 \pm 1,8$ |
| – Aptitude au microcablage (mN) (cablage thermosonique de fil d'or de 30 microns de diamètre) | $96 \pm 7$ | $102 \pm 9$ |
| – Soudabilité (angle de mouillage) | 28° | 23° |

Ces résultats montrent bien que l'addition préférentielle de vapeur d'eau dans la zone d'élimination des résines polymères du four donne des caractéristiques physiques de couches épaisses de cuivre voisines, voire légèrement améliorées, pour la soudabilité, l'aptitude au microcablage et la résistivité, et de loin très améliorées pour l'adhérence aussi bien initiale qu'après vieillissement.

**Revendications**

1. Procédé d'élaboration de moyens de connexion électrique, en particulier de substrats d'interconnexion de circuits hybrides, du genre où l'on effectue sur un support le dépôt d'une couche épaisse d'encre ou pâte à base de métal non noble tel que le cuivre ou autre matériau à formulation "compatible cuivre", un véhicule organique tel que solvants et résines polymères et d'un liant inorganique, en mettant en oeuvre successivement un séchage préliminaire d'élimination des solvants à une température de l'ordre de 100°C à 150°C et une cuisson comprenant successivement :
   a) une montée en température incorporant une phase d'élimination de résines polymères,
   b) un palier de frittage à une température de l'ordre de 600°C à 1000°C, et
   c) un refroidissement temporisé,
   la cuisson étant effectuée sous une atmosphère de gaz substantiellement inerte, le cas échéant avec de faibles teneurs en vapeur d'eau, caractérisé en ce que l'atmosphère de la phase d'élimination des résines polymères présente une teneur en vapeur d'eau comprise entre 50 ppm et 20000 ppm et en ce que l'atmosphère de frittage présente une teneur en vapeur d'eau inférieure à celle de l'atmosphère de la phase d'élimination des résines polymères, et en tout cas inférieure à 1000 ppm, les différentes atmosphères de cuisson étant substantiellement exemptes d'hydrogène.

2. Procédé selon la revendication 1, caractérisé en ce que la teneur en vapeur d'eau de l'atmosphère de la phase d'élimination des résines polymères est comprise entre 1000 et 10000 ppm.

3. Procédé selon la revendication 1, caractérisé en ce que la teneur en vapeur d'eau de l'atmosphère de frittage est inférieure à 250 ppm.

4. Procédé selon l'une des revendications 1 à 3, caractérisé en ce que l'atmosphère de la phase d'élimination des résines polymères comprend de l'oxygène à une teneur pouvant aller jusqu'à quelques dizaines de ppm, alors que la teneur en oxygène de l'atmosphère de frittage et du refroidissement reste toujours inférieure à environ 10 ppm.

5. Procédé selon la revendication 4, caractérisé en ce que l'atmosphère d'élimination des résines polymères est réalisée à partir d'un courant de gaz inerte, auquel on adjoint des proportions d'oxygène et d'hydrogène de formation de vapeur d'eau par réaction catalytique, avec élimination quasi-totale de l'hydrogène, le cas échéant avec un excédent déterminé d'oxygène, de façon à obtenir la teneur prédéterminée en vapeur d'eau et, le cas échéant, la teneur en oxygène.

**Patentansprüche**

1. Verfahren zur Verarbeitung von Mitteln zur elektrischen Verbindung, insbesondere von Substraten für die Verbindung hybrider Schaltkreise miteinander, bei dem auf einen Träger eine dicke Schicht aus Farbe oder einer Paste, die auf einem Nichtedelmetall, wie Kupfer oder einem anderen Stoff "kupferverträglicher" Zusammensetzung, basiert, aus einem organischen Träger, wie Lösungsmittel und Polymerharze, und aus einem anorganischen Bindemittel aufgetragen wird, wobei aufeinanderfolgend eine einleitende Trocknung zur Eliminierung der Lösungsmittel bei einer Temperatur im Bereich von 100°C bis 150°C und eine Aushärtung durchgeführt werden, die folgende Schritte aufweist:
   a) einen Temperaturanstieg einschließlich einer Eliminationsphase von Polymerharzen,
   b) eine Stufe des Sinterns bei einer Temperatur im Bereich von 600°C bis 1000°C und
   c) eine verzögerte Abkühlung,
   wobei die Aushärtung unter einer Atmosphäre aus im wesentlichen inertem Gas, gegebenenfalls mit niedrigem Wasserdampfgehalt durchgeführt wird, dadurch gekennzeichnet, daß die Atmosphäre der Eliminationsphase der Polymerharze einen Wasserdampfgehalt zwischen 50 ppm und 20000 ppm aufweist, und daß die Sinteratmosphäre einen Wasserdampfgehalt aufweist, der niedriger als derjenige der Atmosphäre der Eliminationsphase der Polymerharze, in jedem Fall aber niedriger als 1000 ppm ist, wobei die verschiedenen Atmosphären bei der Aushärtung im wesentlichen frei von Wasserstoff sind.

2. Verfahren nach Anspruch 1, dadurch gekennzeichnet, daß der Wasserdampfgehalt der Atmosphäre der Eliminationsphase der Polymerharze zwischen 1000 und 10000 ppm liegt.

3. Verfahren nach Anspruch 1, dadurch gekennzeichnet, daß der Wasserdampfgehalt der Sinteratmospähre niedriger als 250 ppm ist.

4. Verfahren nach einem der Ansprüche 1 bis 3, dadurch gekennzeichnet, daß die Atmosphäre der Eliminationsphase der Polymerharze Sauerstoff aufweist, dessen Gehalt bis zu einigen 10 ppm gehen kann, während der Sauerstoffgehalt der Sinter- und der Abkühlungsatmosphäre immer unter ca. 10 ppm bleibt.

5. Verfahren nach Anspruch 4, dadurch gekennzeichnet, daß die Atmosphäre der Elimination der Polymerharze von einem inerten Gasstrom ausgehend gebildet wird, dem Sauerstoff- und Wasserstoffanteile zur Bildung von Wasserdampf durch katalytische Reaktion mit fast vollständigem Verbrauch des Wasserstoffs, ggf. mit einem bestimmten Sauerstoffüberschuß, zugegeben werden, um den festgelegten Wasserdampfgehalt und ggf. den Sauerstoffgehalt zu erhalten.

**Claims**

1. Method for elaboration of electrical connection means, in particular, substrates for interconnecting hybrid circuits, of the type where a deposit is made on a supporting medium of a thick layer of ink or paste of a non-noble metal base such as copper or other material of "copper compatible" formulation, an organic carrier such as solvents and polymer resins and an inorganic binder, by bringing into effect successively preliminary drying for eliminating solvents at a temperature of the order of 100°C to 150°C and a baking comprising in succession:

    a) a rise in temperature incorporating a phase for elimination of polymer resins,

    b) a sintering stage at a temperature of the order of 600°C to 1000°C, and

    c) a temporised cooling,

the baking being carried out in an atmosphere of substantially inert gas, if necessary with small percentages of water vapour, characterised in that the atmosphere of the phase for elimination of the polymer resins shows a percentage of water vapour between 50 ppm and 20000 ppm and in that the sintering atmosphere shows a percentage of water vapour less than that of the atmosphere of the phase for elimination of the polymer resins, and in any event less than 1000 ppm, the different baking atmospheres being substantially free of hydrogen.

2.     Method according to claim 1, characterised in that the percentage of water vapour of the atmosphere of the phase for elimination of the polymer resins is comprised between 1000 and 10000 ppm.

3.     Method according to claim 1, characterised in that the percentage of water vapour of the sintering atmosphere is less than 250 ppm.

4.     Method according to one of claims 1 to 3, characterised in that the atmosphere of the phase for elimination of the polymer resins comprises oxygen at a percentage which may reach several tens of ppm, when the percentage of oxygen of the sintering and cooling atmosphere still remains less than approximately 10 ppm.

5.     Method according to claim 4, characterised in that the atmosphere for elimination of the polymer resins is produced by a current of inert gas, to which are added proportions of oxygen and hydrogen to form water vapour by catalytic reaction, with quasi-total elimination of the hydrogen, if necessary with a fixed excess of oxygen, so as to obtain the pre-determined percentage of water vapour and, if necessary the percentage of oxygen.